# EUROPEAN PATENT APPLICATION

(11) **EP 2 299 495 A1**
(43) Date of publication of application: **23.03.2011**
(21) Application number: 09425363.0
(22) Date of filing: 21.09.2009
(51) Int. Cl.: H01L 31/02, G08B 13/14, H02N 6/00

(54) **Antitheft device for use in a system for converting solar energy into electrical energy**

(71) Applicant: Cityware Engineering S.r.l., 35129 Padova (PD) (IT)
(72) Inventor: Franceschini, Leopoldo, 35133 Padova (IT); Marconi, Raffaella, 35133 Padova (IT)
(74) Representative: Ciceri, Fabio

(57) **Abstract**

The present invention concerns a system for converting solar energy into electrical energy comprising a photovoltaic generator with a plurality of photovoltaic modules (4). The system is **characterized in that** it comprises an electronic device (5) associated with each photovoltaic module of said plurality of photovoltaic modules (4), said electronic device (5) comprising a memory (5A) that contains a pre-stored numeric code; presence/absence checking means (6) in signal communication with said electronic device (5), said presence/absence checking means (6) being designed to transmit an actuation signal (Sa) to said electronic device (5) of each photovoltaic module (4) to cause said electronic device (5) to generate a corresponding output signal (Su); compare each output signal (Su) with a corresponding reference signal (Srif), the latter being representative of the numeric code stored by the corresponding electronic device being actuated and generate a presence/absence signal (S) resulting from the comparison between said output signal (Su) and said reference signal (Srif).

## Description

The present invention relates to an antitheft device for use in a system for converting solar energy into electrical energy as defined in the preamble of claim 1.

In systems for converting solar energy into electrical energy, photovoltaic cells are known to be the components with the highest relative cost, which most increase overall system costs. These cells form the so-called solar panels that convert solar energy into electrical energy as their active surface is radiated by sunlight, due to the silicon-containing material that constitutes such active surface.

Multiple photovoltaic cells connected together are known as "photovoltaic module". Photovoltaic modules are connected in series and can be easily disassembled and/or separated for a more flexible employment and use of the conversion system. Hence, photovoltaic modules may be added or removed as needed to fulfill various power generation requirements.

The above mentioned conversion systems are at risk of large-scale theft, because they are generally installed in sunny outdoor areas and may also cover very large surfaces. Panels are installed in isolated areas both for improved insolation and for dimensional reasons, because industrial conversion systems, having a minimum power of 1MWh, extend over surfaces of about 4-5 hectares and typically out of town.

Also, theft of photovoltaic panels from conversion systems is motivated by panel modularity, high panel value, and by the possibility of easily reselling and reusing the panels, once they have been removed, without making any change to them.

In an attempt to obviate this drawback, antitheft systems have been used which include fences, video surveillance systems and manned surveillance. Nevertheless, these have been found to be inadequate measures and to also involve high costs, especially in small conversion systems. In the latter case, the antitheft device would have about the same cost as the conversion system itself.

In view of the above state of the art, the object of the present invention is to provide a system for converting solar energy into electrical energy whose features are designed to fulfill the above needs, while obviating the above described prior art drawbacks.

According to the present invention, this object is fulfilled by a system for converting solar energy into electrical energy as defined in the accompanying claims.

With the present invention, one photovoltaic panel is identified in the conversion system so that a check can be timely made to ascertain whether it is present and/or absent, e.g. due to unauthorized removal thereof from the conversion system.

Furthermore, with this invention, the antitheft device may be adapted to various types of conversion systems (stationary, with tracking arrangement, roof-mounted, etc.), and easily implemented on operating conversion systems.

With the present invention, the antitheft device further has simple electric connections, to facilitate data transfer and substantially prevent removal of any photovoltaic panel without generating an alarm signal.

Furthermore, with the present invention, a low-cost, reliable and scalable antitheft device may be implemented for each panel.

Also, with the present invention, alarm management and panel presence/absence supervision may be remotely handled, for cost-effective surveillance of one or more conversion systems, a common surveillance center being possibly provided for supervising multiple conversion systems.

The characteristics and advantages of the invention will appear from the following detailed description of one practical embodiment, which is illustrated without limitation in the annexed drawings, in which:
- Figure 1 is a simplified diagrammatic view of a system for converting solar energy into electrical energy according to the present invention;
- Figure 2 is a block diagram of an embodiment of an electronic device of the conversion system of the invention.

Referring to the annexed figures, numeral 1 generally designates a conversion system of the present invention.

The inventive system is capable of converting solar energy into electrical energy, the latter being usable both for feeding power into the mains (grid-connected system) and/or for power storage in rechargeable batteries or the like (stand-alone system).

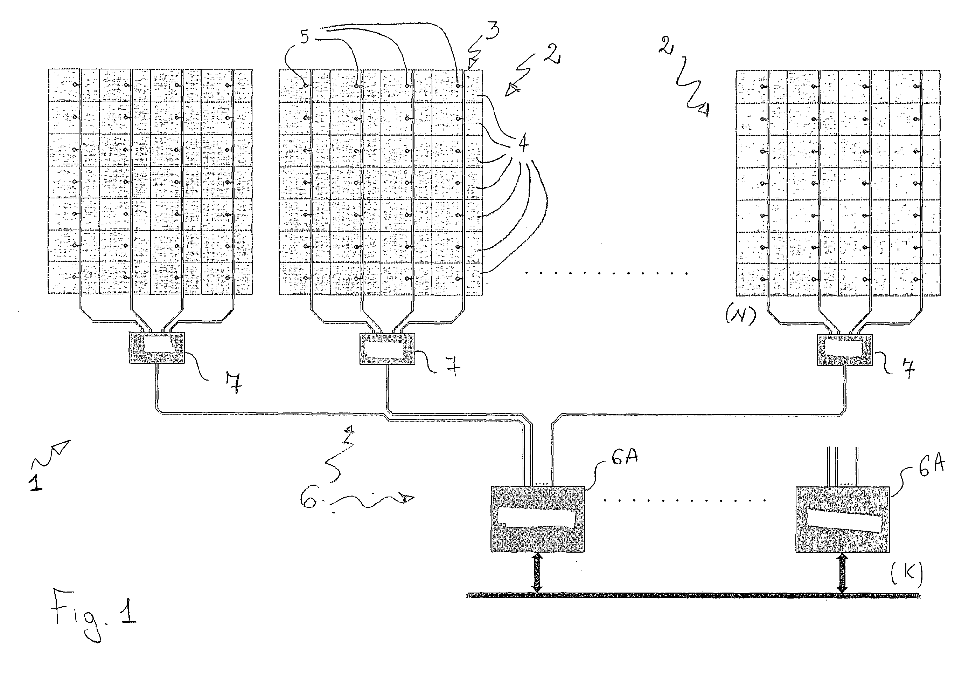

Particularly referring to Figure 1, the system 1 comprises one or more arrays 2 (N arrays being shown in the figure), each comprising one or more strings 3 of photovoltaic modules (M strings being shown in the figure). Each string 3 is in turn composed of a plurality of photovoltaic modules 4 (Z photovoltaic modules being shown in the figure).

The photovoltaic modules 4 are electrically connected in series, whereas the strings 3 are electrically connected in parallel or in series (depending on system requirements), and are usually termed as a whole "photovoltaic generator".

Each photovoltaic module 4, as known by those of ordinary skill in the art, is composed of a plurality of photovoltaic cells.

It shall be noted that the number of strings, as well as the type and amount of cells to be used for implementation of the system 1 depend on a number of factors, among which the overall power of the system, its position, irradiation at the installation site, etc. shall be accounted for.

For example, in the configuration as shown in Figure 1, each of the N arrays 2 comprises twenty-eight photovoltaic modules 4, i.e. four strings 3 with seven photovoltaic modules each 4.

For instance, a conversion system generating about 1MW power may include up to two hundred arrays (N=200), which makes up five thousand six hundred photovoltaic modules 4.

Each of these photovoltaic modules 4 comprises an electronic device 5, which is preferably permanently associated with each photovoltaic module 4.

Particularly, each electronic device 5 is glued on either surface of the photovoltaic module 4. Preferably, the surface on which the electronic device 5 is glued with two-component epoxy resins is the one that is not exposed to solar radiation, i.e. the non active surface of the photovoltaic module 4 or the metal frame of the photovoltaic module.

In one embodiment, the electronic device 5 may be embedded or encapsulated in a polymer material for weather protection (a part of it is tropicalized).

Otherwise, the electronic device 5 may be inserted, housed or integrated in the material that constitutes the photovoltaic panel by the manufacturer of the panel.

As shown in Figure 1, using the above reference numerals, each string 3 has up to seven electronic devices 5, each associated with its respective photovoltaic module. Particularly, the electronic devices 5 of a string 5 form a branch of a circuit.

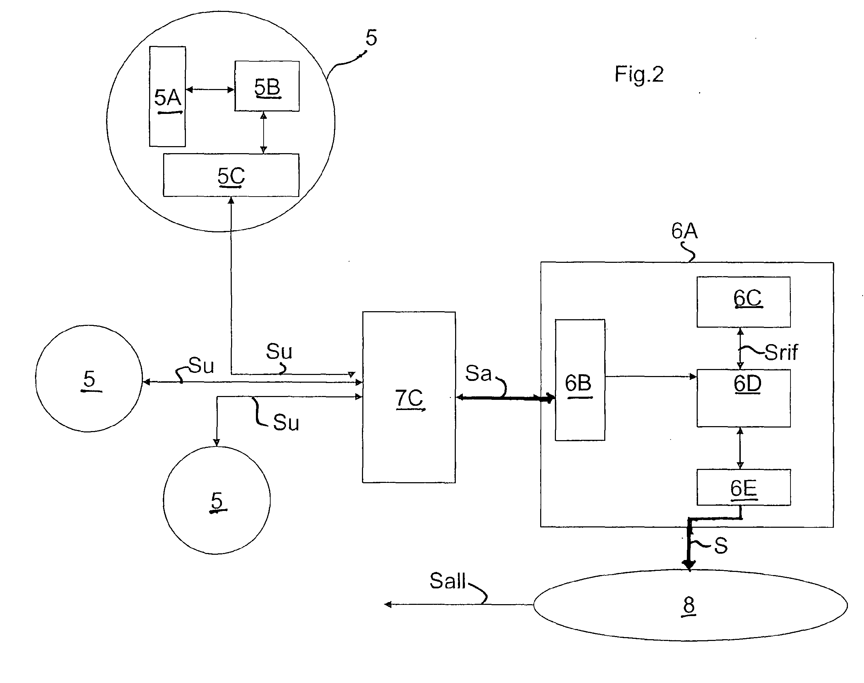

Referring to Figure 2, a possible implementation of the electronic device 5 is shown, which comprises a storage device (i.e. a memory ) 5A, a control logic 5B and an input/output interface 5C.

The memory 5A of the electronic device 5 is a non volatile memory and contains a numeric code having or exceeding a 8-bit length, preferably a 64-bit code. Such numeric code indicates the family of the device, the ID code of the device as well as a checksum code useful for reading.

The numeric code is advantageously pre-stored in the memory 5A by the manufacturer of the electronic device 5 before association of the electronic device with the photovoltaic module 4. Hence, the numeric code will be certainly safe and unique.

Furthermore, the 64-bit length of the numeric code allows the use of a large number of electronic devices for the purposes that will be described in greater detail hereinafter.

In one embodiment, the electronic device associated with the memory 5A covers a maximum area of 2 square centimeters and is about one half millimeter thick, to facilitate both integration with the non active surface of the photovoltaic module 4 and concealment.

In addition to the provision that each photovoltaic module 4 be associated with a corresponding electronic device 5, the conversion system 1 comprises presence/absence checking means 6 which are in signal communication with the electronic device 5 to check whether one or more photovoltaic modules 4 are present or not.

For this purpose, the presence/absence checking means 6 are designed to:
- transmit an actuation signal Sa to the electronic device 5 of each photovoltaic module 4 to cause the electronic device 5 to generate a corresponding output signal Su;
- compare each output signal Su with a corresponding reference signal Srif, the latter being representative of the numeric code stored in the memory 5A by the corresponding electronic device 5 being actuated and
- generate a presence/absence signal S resulting from the comparison between said output signal Su and said reference signal Srif.

Particularly, the actuation signal Sa is routed through the input/output interface 5C to actuate the control logic 5B and cause it to read the numeric code contained in the memory 5A so that the control logic 5B of the electronic device 5 being actuated generates the output signal Su and outputs it through the input/output interface 5C.

Once the actuated electronic device 5 has generated its output signal Su, the presence/absence checking means 6 compare the output signal Su with a corresponding reference signal Srif, the latter being representative of the numeric code stored in the memory 5A by the actuated electronic device 5, i.e. the electronic device that generated that particular output signal Su.

If the result of the comparison is that the output signal Su of the actuated electronic device 5 matches the reference signal Srif of the same signal, then the photovoltaic module 4 with which that particular electronic device 5 is associated has not been removed or damaged, i.e. is still part of the string 3 of the array 2. Otherwise, if the two signals do not match, then the photovoltaic module 4 with which that particular electronic device 5 is associated has been removed.

The presence/absence checking means 6 include at least one electronic card 6A, to receive the output signal Su.

A number K of electronic cards 6A are shown in the diagrammatic figure. Particularly, each electronic card 6A comprises:
- a first input/output interface 6B to establish signal communication with the input/output interface 5C of the electronic device 5 to transmit the actuation signal Sa to the electronic device and receive the generated output signal Su from the actuated electronic device 5,
- a mass storage device 6C (or memory) and
- a microcontroller 6D having a program code or firmware adapted to:
   - compare each output signal Su with said corresponding reference signal Srif, the latter being representative of the numeric code stored in said corresponding actuated electronic device 5 and
   - generate the presence/absence signal S resulting from the comparison between the output signal Su and said reference signal Srif.

Particularly, the memory of the electronic card 6A stores the numeric code of each electronic device 5 that is part of the conversion system 1.

In other words, the memory 6C of the electronic card 6A stores the information content of the reference signals Srif.

For instance, in order to store the numeric code of each electronic device 5 in the memory of the electronic card 6A, the codes stored in the memories 5A are first read and then stored in the memory 6C.

Depending on the size of the conversion system 1 and hence on the number of arrays 2 installed, a large number of photovoltaic modules 4 to be checked is obtained.

In order to eliminate or at least limit reflections and interferences in the output signal Su generated by the electronic devices 5 individually or simultaneously actuated by the presence/absence checking means 6, and thus reach the best transmission conditions, communication between the input/output interface 5C of each electronic device 5 and the input/output interface 6B of the electronic card 6A is established through a connection bus, preferably of single-wire type.

Such single-wire connection may be also implemented by a stranded cable, having impedance-matching electronics.

Such single-wire bus may be installed in an exposed arrangement, and still cause no system safety problem.

In a preferred embodiment, the single-wire connection between the electronic device 5 and the card 6A is established in half-duplex asynchronous mode and, in the rest state, such single-wire connection bus also ensures power supply to the electronic device 5.

For management of the single wire for each electronic device 5, the presence/absence checking means 6 include at least one router 7 interposed between an array 2 and the electronic card 6A.

Therefore, the router 7 provides efficient connection between the multitude of electronic devices 5 of the conversion system 1 and the electronic card 6A.

Management of a large number N of arrays 2 requires hundreds or thousands of electronic devices 5 to be checked.

In a preferred connection arrangement, the electronic devices 5 may be connected by several branches, which are in turn connected together via at least one router 7.

The electronic devices 5 in each branch may be as many as one hundred.

The number of routers 7 is equal to the number N of the arrays 2 of the conversion system.

In this configuration, the router 7 may handle up to thirty-two channels, i.e. receive input connections of up to thirty-two arrays, each of said channels being capable of routing the single-wire connections of one branch of the electronic devices 5.

Therefore, the strings 3 of an array 2 communicate with a corresponding router 7, and the routers 7 of each array 2 of the conversion system 1 are in turn connected to the input/output interface 6B of the electronic card 6A via the router 7.

In view of the above description of the single-wire connection arrangement, each router 7 may be designed to:
- receive a corresponding single-wire connection from each electronic device 5 to allow signal communication with the single-wire connections of the electronic devices associated with the plurality of photovoltaic modules 4 of the array 2;
- receive a connection bus from said electronic card 6A, to route the actuation signal Sa to the electronic device 5 to be actuated and
- select, according to said actuation signal Sa, one or more of said electronic devices 5 to generate a corresponding output signal Su.

Preferably, in order to reduce the burden required for reading the memories 5A of the electronic devices 5 as well as the problems connected to a network with many nodes (signal reflection), the presence/absence checking means 6 select a single array, i.e. a single router 7 during the reading step. Continuous cyclic query about the presence of the electronic devices 5 connected to their respective photovoltaic module 4 quickly confirms whether the photovoltaic module 4 has been removed or not.

Particularly the step of selecting one or more electronic devices 5 of an array 2, according to the actuation signal Sa, to read the respective numeric codes stored in each memory 5A may be carried out by a switch implemented, for instance, in software form in the router 7.

The electronic card 6A also comprises a second input/output interface 6E with a remote control center 8, which is designed to generate an alarm signal Sall as a result of the presence/absence signal S.

Particularly, the connection with the remote control center is of the type that comprises a wired connection, i.e. RS485, Ethernet, or a wireless connection, such as gsm, Zigbee or the like.

It shall be noted that each array 2 is configured as a matrix, in which the photovoltaic module 4 and its respective electronic device 5 are situated at the crossing points of the rows and columns.

This matrix may be graphically represented as a synoptic panel, to allow an operator at the control center 8 to timely and effectively identify the area in which a photovoltaic module 4 has been removed.

In view of the above description of the conversion system 1 and assuming that each array 2 may be configured as a matrix, the presence/absence checking means 6 of the conversion system 1 first read and acquire all the numeric codes stored in each memory 5A, to form a first matrix, i.e. an initialization matrix.

Such initialization matrix is stored in the memory 6C of the electronic card 6A. This is the reference matrix that contains the correct numeric codes of each photovoltaic module 4 of each array 2.

After storage of the initialization matrix, the checking means 6 cyclically read one or more numeric codes of a photovoltaic module or a set of photovoltaic modules or an array, and thus create a new matrix of codes.

The presence/absence checking step is carried out by the checking means 6, with the presence/absence signal S being generated as a result of an exclusive OR operation (XOR Boolean operator) on the elements of the initialization matrix and the second matrix.

The result of this comparison provides a third matrix. If the elements of the third matrix are zero, then the initialization matrix and the second matrix match (normal operating state, with the presence/absence signal S certifying the presence of the photovoltaic module 4), whereas if one or more elements of the third matrix are non-zero values, there arises an alarm condition (with the presence/absence signal S certifying the absence of the photovoltaic module 4).

Each non-zero element of the third matrix causes the presence/absence checking means 6 to transmit a presence/absence signal S, via the microcontroller of the card 6A, to the remote control center 8, to generate the alarm signal Sall. Advantageously, the electronic card 6A queries each router 7 in polling mode, which means that the routers 7 are cyclically queried.

The need of operating in polling mode derives by the possibility that the router 7 may be tampered, which condition could not be identified in interrupt mode. Therefore, a lack of a reply by the router to the query of the electronic card 6A triggers an alarm, which will be generated and transmitted to the remote control center 8.

Those skilled in the art will obviously appreciate that a number of changes and variants may be made to the arrangements as described hereinbefore to meet specific needs, without departure from the scope of the invention, as defined in the following claims.

## Claims

1. A system for converting solar energy into electrical energy comprising a photovoltaic generator with a plurality of photovoltaic modules (4), **characterized in that** it comprises:
- an electronic device (5) associated with each photovoltaic module of said plurality of photovoltaic modules (4), said electronic device (5) comprising a memory (5A) with a pre-stored numeric code;
- presence/absence checking means (6) in signal communication with said electronic device (5), said presence/absence checking means (6) being designed to:
- transmit an actuation signal (Sa) to said electronic device (5) of each photovoltaic module (4) to cause said electronic device (5) to generate a corresponding output signal (Su);
- compare each output signal (Su) with a corresponding reference signal (Srif), the latter being representative of the numeric code stored by the corresponding electronic device 5 being actuated and
- generate a presence/absence signal (S) resulting from the comparison between said output signal (Su) and said reference signal (Srif).

2. A system for converting solar energy into electrical energy as claimed in claim 1, wherein each of said electronic devices (5) comprises a control logic (5B) in signal communication with said memory (5A) and an input/output interface (5C), said actuation signal (Sa) being adapted to actuate said control logic (5B) through the input/output signal (5C) to read said numeric code pre-stored in said memory (5A), said input/output interface (5C) being designed to interface with said presence/absence checking means (6).

3. A system for converting solar energy into electrical energy as claimed in claim 2, wherein said presence/absence checking means (6) comprise at least one electronic card (6A) having:
- a first input/output interface (6B) to establish signal communication with said input/output interface (5C) of the electronic device (5) to transmit the actuation signal (Sa) to the electronic device and receive the generated output signal (Su) from said actuated electronic device,
- a microcontroller (6D) having a program code or adapted to:
- compare each of said output signals (Su) with said corresponding reference signal (Srif), the latter being representative of the numeric code stored by said corresponding actuated electronic device and
- generate said presence/absence signal (S) resulting from the comparison between said output signal (Su) and said reference signal (Srif).

4. A system for converting solar energy into electrical energy as claimed in claim 2 or 3, wherein communication between said input/output interface (5C) of each electronic device (5) and said presence/absence checking means (6) is established through a single-wire connection bus.

5. A system for converting solar energy into electrical energy as claimed in claim 4, comprising at least one router (7) in signal communication between each electronic device (5) and said electronic card (6A), said at least one router (7) being designed to:
- receive a corresponding single-wire connection from each electronic device (5) to receive the single-wire connections of the electronic devices associated with the plurality of photovoltaic modules (4) and to receive a connection wire from said electronic card (6A) to transmit said actuation signal (Sa) for actuating said electronic device,
- select, according to said actuation signal (Sa), one or more of said electronic devices (5) to generate a corresponding output signal (Su).

6. A system for converting solar energy into electrical energy as claimed in claim 3, wherein said electronic card (6A) comprises a storage (6C) adapted to contain said numeric codes of the electronic devices (5) and a second input/output interface (6E) adapted to interface with a remote control center (8) away from said conversion system (1), said remote control center (8) being designed to generate an alarm signal (Sall) in response to said presence/absence signal (S).

7. A system for converting solar energy into electrical energy as claimed in claim 6, wherein said connection between the electronic card (6A) with said control center (8) is of the type comprising a wired or wireless connection.

8. A system for converting solar energy into electrical energy as claimed in claim 1, wherein each electronic device (5) is attached to the photovoltaic module (4) by being glued on the non active surface of said photovoltaic module (4).

9. A system for converting solar energy into electrical energy as claimed in claim 1, wherein each electronic device (5) is integrated in the photovoltaic module (4).

10. A system for converting solar energy into electrical energy as claimed in claim 1, wherein each electronic device (5) is made from a material adapted for exposure to weather, and protected by an casing made of a material such as steel or PVC.

11. A system for converting solar energy into electrical energy as claimed in claim 1, wherein said numeric code contained in said memory of said electronic device is a numeric code is a numeric code having or exceeding a 8-bit length.

12. A photovoltaic module for a system for converting solar energy into electrical energy, **characterized in that** it comprises an electronic device (5) having a memory (5A) that contains a pre-stored numeric code, said electronic device (5) being associated with the photovoltaic module (4).

13. A photovoltaic module as claimed in claim 12, wherein said electronic device (5) is attached to the photovoltaic module (4) by being glued on the non active surface of said photovoltaic module (4).

14. A photovoltaic module as claimed in claim 12, wherein said electronic device (5) is integrated in the material that constitutes said photovoltaic module (4).
